# EUROPEAN PATENT APPLICATION

(11) **EP 1 698 938 A2**
(43) Date of publication of application: **06.09.2006**
(21) Application number: 06003849.4
(22) Date of filing: 24.02.2006
(51) Int. Cl.: G03F 7/20

(54) **Atmosphere conditioning method, exposure apparatus, and device manufacturing method**

(30) Priority: 01.03.2005 JP 2005055499
(71) Applicant: CANON KABUSHIKI KAISHA, Ohta-ku, Tokyo (JP)
(72) Inventor: Biro, Ryuji, Ohta-ku Tokyo (JP)
(74) Representative: Weser, Wolfgang

(57) **Abstract**

A method is provided of conditioning an atmosphere inside a chamber (20) of an exposure apparatus in which an optical element (2) is disposed for directing light (A) to expose a substrate (3). The method includes the steps of supplying inert gas into the chamber (20) and exhausting gas from the chamber (20). The supplying step adjusts the flow rate of the inert gas so that the amount of impurities supplied into the chamber (20) is not greater than 2 nanograms per minute per 1 liter of a volume of the chamber (20).

## Description

### BACKGROUND OF THE INVENTION

### Field of the Invention

The present invention relates to a technique of reducing contamination of an optical element in an exposure apparatus which utilizes light having a short wavelength emitted from a laser light source or the like.

### Description of the Related Art

In recent years, further improvement in microfabrication of semiconductor elements and farther increase in throughput thereof have been increasingly desired. In response to these desires, in a semiconductor exposure apparatus, a light source that emits light having a shorter wavelength has been progressively used for further improvement in microfabrication, and light having a higher energy has also been progressively used for improvement in productivity. However, when light having a shorter wavelength is used, various technical issues must be overcome that involve the atmosphere through which the light travels, the glass material through which light passes, the transmissive and reflective coating films formed on glass surfaces, and the like. In particular, the control of the atmosphere in an optical chamber in which an optical system is disposed becomes a more important technical subject as the wavelength of light used therein is further decreased.

In general, the transmittance of light having a short wavelength is decreased in the air. Hence, when light having a short wavelength is used as a light source, a method for improving the transmittance of an optical system has been developed. In this method, a gas having a superior transmittance with respect to emitted light is inputted into an optical chamber in which the above optical system is disposed. As the gas used in this method, an inert gas, such as nitrogen, argon, helium, neon, xenon, or krypton, may be used. In addition, the purity of the gas to be used in the optical chamber is correlated with the light transmittance, and hence, as the purity of the gas is improved, the light transmittance thereof is further improved.

In Japanese Patent Laid-Open No. 8-55774, a technique has been disclosed in which a highly pure gas is supplied in a semiconductor exposure apparatus by using a filter. Although the flow rate of a gas supplied in a semiconductor exposure apparatus depends on the volume thereof, the supply is generally performed at a flow rate of approximately 100 liters/minute. The reason for this is to enable the gas present in the apparatus to always have a high purity.

However, even when the filter is used as disclosed in Japanese Patent Laid-Open No. 8-55774, it is not possible to totally remove impurities, and a slight amount of impurities inevitably remains. Hence, 100 liters of a nitrogen gas, which is obtained from liquid nitrogen and which is used as a highly pure gas in a semiconductor exposure apparatus or the like, was analyzed using a gas chromatography mass spectrometer (hereinafter referred to as "GCMS"). The results are shown in Table 1.

**Table 1 GAS ANALYSIS BY GCMS**

| COMPOUNDS | CONCENTRATION (ng/m³) |
|---|---|
| Benzaldehyde | 80 |
| Phenol | 54 |
| Acetophenone | 51 |
| Octanal | 38 |
| Siloxane + Benzoic Acid | 93 |
| Aliphatic Hydrocarbon | 18 |
| Tetramethylene Sulfone | 34 |
| Aliphatic Hydrocarbon | 17 |
| Phthalic Anhydride | 35 |
| Siloxane | 24 |
| Tetradecane | 85 |
| 2,6-Di-tert-butyl-4-bromomethyl phenol | 170 |
| Pentadecane | 63 |
| Heptadecane | 260 |

As can be seen from Table 1, from 100 liters of the highly pure nitrogen gas, approximately 1,000 ng of total impurities was detected, and the total concentration thereof was 1 ppm or less. In general, the amount of impurities as described above does not substantially influence the transmittance of an optical element forming an optical system. Hence, in the past, the impurities described above have not been regarded as causing problems. However, in practice, when exposure light is transmitted through the optical system while a highly pure gas as shown in Table 1 is being supplied in a semiconductor exposure apparatus at a flow rate of 100 liters/minute, the transmittance of the optical element in the optical system considerably decreases with time.

Through intensive research carried out by the inventor of the present invention, it was found that this slight amount of impurities reacts with light using a specific element present on an optical element surface as a catalyst so as to form a new contaminant on the optical element surface. In particular, since a coating film such as an anti-reflection film generally provided on the optical element surface contains a small amount of a catalytic metal that forms a surface contaminant, the rate of generating the surface contaminant is disadvantageously increased. It was found that since the contaminant formed on the optical element surface has a low transmittance, the transmittance of the optical element is considerably decreased.

### SUMMARY OF THE INVENTION

The present invention provides a novel technique of reducing contamination of an optical element in an exposure apparatus.

In accordance with a first aspect of the present invention, there is provided a method for conditioning an atmosphere inside a chamber of an exposure apparatus in which an optical element is disposed for directing light to expose a substrate. The method comprises the steps of supplying an inert gas in the chamber and exhausting gas from the chamber. The supplying step adjusts the flow rate of the inert gas so that the amount of impurities supplied into the chamber is 2 ng or less per minute per 1 liter of the volume of the chamber. The supplying step preferably supplies inert gas at a flow rate not less than 0.01 liters per minute per 100 liters of the volume of the chamber. In addition, the wavelength of the light is preferably not greater than 250 nanometers_and the energy density of the light is not less than 10 mJ/cm² in at least one region of a surface of the optical element. Further, the inert gas includes at least one element selected from the group consisting of argon, nitrogen, helium, neon, xenon, and krypton. Also, the method further comprises the step of transmitting light through the optical system to the substrate during the supplying and exhausting steps. Moreover, the method can also comprise the step of measuring the total weight of the impurities contained in the inert gas per unit volume before Ihe supplying and exhausting steps.

In accordance with a second aspect of the present invention, there is provided an exposure apparatus for exposing a substrate to light, comprising an optical element configured to direct the light, a chamber configured to enclose the optical element, a supply system configured to supply an inert gas into the chamber, and an exhaust system configured to exhaust gas from the chamber. The above supply system is configured to adjust the flow rate of the inert gas so that the amount of impurities supplied into the chamber is 2 ng or less per minute per 1 liter of volume of the chamber. The supply system is also configured to supply the inert gas at a flow rate not less than 0.01 liters per minute per 100 liters of the volume of the chamber. In addition, the optical element is configured to direct the_light whose wavelength is not greater than 250 nanometers. Also, the apparatus is configured so that the energy density of the light is not less than 10 mJ/cm² in at least one region of a surface of the optical element. Moreover, the supply system is configured to supply the inert gas which includes at least one element selected from the group consisting of argon, nitrogen, helium, neon, xenon, and krypton. Further, the light is transmitted through the optical system during the supplying of inert gas by the supply system and during the exhausting of gas by the exhaust system. Also, the supply system can further comprise a flowmeter configured and positioned to measure the flow rate of the inert gas supplied by the supply system, and at least one valve configured and positioned to control the flow rate of the inert gas supplied by the supply system.

In accordance with a third aspect of the present invention, there is provided a method for manufacturing a device, comprising the steps of supplying inert gas into a chamber of an exposure apparatus for exposing a_substrate to light directed thereto by an optical element in the chamber, exhausting gas from the chamber, adjusting the flow rate of the inert gas so that the amount of impurities supplied into the chamber is not greater than 2 nanograms per minute per 1 liter of a volume of the chamber, exposing the substrate to light directed thereto by the optical element using the exposure apparatus, developing the exposed substrate, and processing the developed substrate to manufacture the device. The supplying step supplies inert gas at a flow rate not less than 0.01 liters per minute per 100 liters of the volume of the chamber. The wavelength of the light is not greater than 250 nanometers. The energy density of the light is not less than 10 mJ/cm² in at least one region of a surface of the optical element. The inert gas includes at least one element selected from the group consisting of argon, nitrogen, helium, neon, xenon, and krypton. In addition, the method can further comprise the step of transmitting light through the optical system to the substrate during the supplying and exhausting steps.

Other objects and advantages besides those discussed above shall be apparent to those skilled in the art from the description of preferred embodiments of the invention which follows. In the description, reference is made to accompanying drawings, which form a part thereof, and which illustrate examples of the invention. Such examples, however, are not exhaustive of the various embodiments of the invention, and therefore reference is made to the claims which follow the description for determining the scope of the invention.

### BRIEF DESCRIPTION OF THE DRAWINGS

The accompanying drawings, which are incorporated in and constitute a part of the specification, illustrate embodiments of the invention and, together with the description, serve to explain the principles of the invention.

Fig. 1 is a schematic view of an exposure apparatus according to Embodiment 1 of the present invention.

Fig. 2 is a schematic view of an experimental device according to Embodiment 1 of the present invention.

Fig. 3 is a graph showing experimental results of Experimental example 1.

Fig. 4 is a graph showing experimental results of Experimental example 2.

Fig. 5 is a graph showing experimental results of Experimental example 3.

Fig. 6 is a flowchart of a device manufacturing process of Embodiment 2 of the present invention.

### DESCRIPTION OF THE EMBODIMENTS

### Embodiment 1

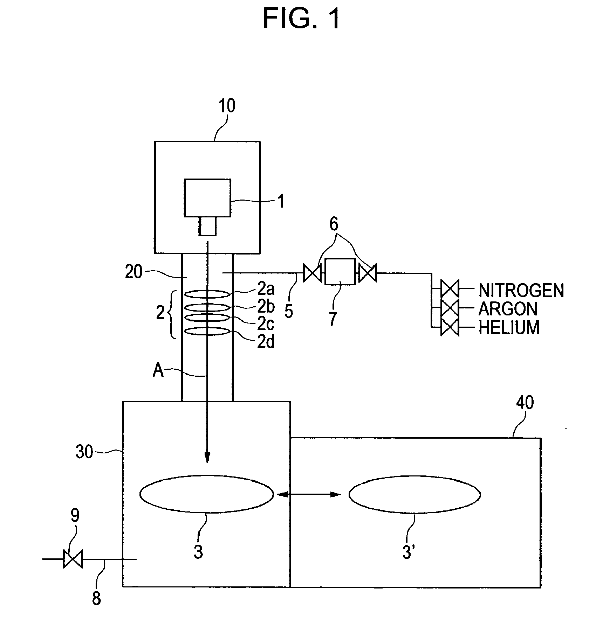

In Fig. 1, a schematic view of an exposure apparatus according to Embodiment 1 is shown. In Fig. 1, reference numeral 1 denotes a light source which is disposed in a light source chamber 10. As the light source 1, a light source having a wavelength of 250 nm or less is used. For example, an F₂ laser having a wavelength of 157 nm, an ArF laser having a wavelength of 193 nm, or a KrF laser having a wavelength of 248 nm is used. In addition, for cleaning or the like of an optical element, for example, a low pressure mercury lamp having bright lines at wavelengths of 185 nm and 254 nm may also be used.

The reaction described above between light and a slight amount of impurities contained in a gas supplied to the optical chamber is liable to occur when a light source having a wavelength of 250 nm or less is used, and as a result, a contaminant is liable to be produced on optical element surfaces. Hence, the effect of the present invention to substantially decrease the contamination on this surface is particularly evident when a light source having a wavelength of 250 nm or less is used. But the present invention will also reduce contamination when light of a wavelength of more than 250 nm is used.

In addition, in order to improve the throughput in a semiconductor exposure step, in recent years, there has been a trend to increase the light energy. In particular, when the light energy density is increased to 10 mJ/cm² or more, since the intensity of light is high, a contaminant is liable to be produced on the optical element surfaces. That is, when at least one position on the optical element surfaces is exposed to light having an energy density of 10 mJ/cm² or more, the effect of the present invention to substantially reduce contamination of the optical element surfaces is particularly evident. But the present invention will also reduce contamination of the optical element surfaces when at least one position on the optical element surfaces is exposed to light having an energy density of less than 10 mJ/cm². In this example, the light source 1 is provided so that at least one position on the optical element surfaces is exposed to light having an energy density of 10 mJ/cm² or more.

Reference numeral 2 denotes an optical system which shapes laser light A (arrow) emitted from the laser light source 1 and which is formed of 4 lenses 2a, 2b, 2c, and 2d shown in Fig. 1. The lenses 2a, 2b, 2c, and 2d are precisely placed at predetermined positions in a lens barrel not shown in the figure and are also disposed inside an optical system container 20. On the surfaces of the lenses 2a, 2b, 2c and 2d, thin films (anti-reflection films) may be formed. By forming the thin films, the reflection on the lens surfaces can be prevented, and hence a high transmittance can be obtained. In the actual optical system 2, its design is constructed in accordance with the wavelength of a light source; however, in order to facilitate the understanding of the present invention, the most general structure is shown in Fig. 1.

Reference numeral 3 denotes a semiconductor substrate which is to be exposed to the light A and is disposed at a predetermined position inside an irradiation chamber 30. After being exposed, the semiconductor substrate 3 is replaced with an unexposed semiconductor substrate 3' placed in a replacement chamber 40 which is disposed adjacent to the irradiation chamber 30.

In the optical system container 20, one of nitrogen, argon, helium, and a mixture thereof is supplied from a gas supply pipe 5. In order to control the atmosphere inside the optical system container 20, valves 6 and a flowmeter 7 are provided at predetermined places of the gas supply pipe 5. In addition, for the irradiation chamber 30, a gas exhaust pipe 8 is also provided. A valve 9 for controlling an exhaust gas amount is provided at a predetermined place of the gas exhaust pipe 8. The atmosphere inside the optical system container 20 is always filled with a new gas by always supplying a gas from the gas supply pipe 5 and exhausting a gas in the chamber 30 with the gas exhaust pipe 8. The amount of the gas supplied from the gas supply pipe 5 is controlled and can be predetermined by using the valves 6 based on the value measured by the flowmeter 7.

In this example, the exposure apparatus has been described by way of example; however, the present invention is not limited thereto, and in a manner similar to that described above, the present invention may also be applied to a system having an optical element and the like which are exposed to light having a short wavelength such as laser light.

In the exposure apparatus shown in Embodiment 1 having the structure as described above, the transmittances of the lenses 2a, 2b, 2c and 2d of the optical system 2 of the above exposure apparatus are prevented from being decreased as a function of the exposure time during which the lenses are exposed to light. However, since it is difficult to perform an experiment in an actual semiconductor exposure apparatus, by using the following simple experimental device, the effect of the present invention was confirmed.

### Experimental examples

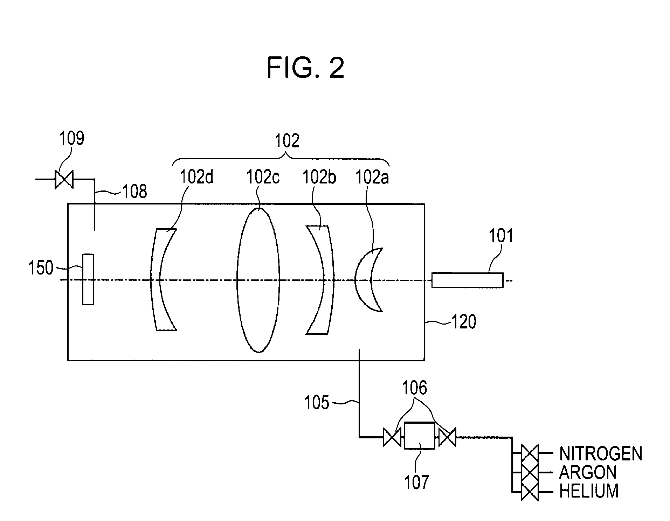

Fig. 2 is a schematic view of the experimental device mentioned above. In Fig. 2, reference numeral 101 denotes a light source corresponding to the light source 1 in Fig. 1. Reference numeral 102 denotes an optical system for shaping light emitted from the light source 101 and is formed of four lenses, meniscus lenses 102a and 102b, a biconvex lens 102c, and a meniscus lens 102d. The lenses 102a, 102b, 102c, and 102d are precisely placed at predetermined positions in a lens barrel not shown in the figure and are also disposed in a stainless steel container 120. Reference numeral 150 denotes a detector for detecting the amount of light passing through the optical system 102.

In the stainless steel container 120, nitrogen, argon, helium or a mixture thereof is supplied from a gas supply pipe 105. In order to control the atmosphere inside the stainless steel container 120, valves 106 and a flowmeter 107 are provided at predetermined places in the gas supply pipe 105. In addition, a gas exhaust pipe 108 is also provided at a predetermined place in the stainless steel container 120. At a predetermined place in the gas exhaust pipe 108, a valve 109 controlling the exhaust gas amount is provided. The atmosphere inside the stainless steel container 120 is always filled with a new and highly pure gas by supplying gas from the gas supply pipe 105 and by exhausting a gas from the container with the gas exhaust pipe 108 in an amount approximately equivalent to that of the above supplied gas. In this case, when the flow rate of the gas which is supplied is not less than approximately 0.01 liters/minute per 100 liters of volume of the stainless steel container 120 which is to be filled with the gas, a sufficiently high purity can be maintained.

The weight of impurities contained in the gas supplied from the gas supply pipe 105 is analyzed beforehand by a GCMS or the like so as to determine the total weight of impurities contained in the gas per unit volume. Based on this measured value, the flow rate of the gas supplied from the gas supply pipe 105 is controlled by the flowmeter 107 so as not to allow impurities in an amount larger than a specified value to flow into the optical system. Laser light passing through the optical system 102 is converged on the detector 150, and the amount of the light is detected thereby. When transmission light used as a reference is measured, the measurement is performed after all the lenses 102a, 102b, 102c and 102d are removed. In this case, the amount of light detected by the detector 150 is regarded as 100% and is compared with the value measured in a state in which the optical system is actually provided.

### Experimental example 1

Experimental example 1 was carried out using the experimental device shown in Fig. 2. An F₂ laser having a wavelength of 157 nm was used as the light source 101, and the highest energy density on the meniscus lens 102a was 15 mJ/cm². The inside volume (volume) of the stainless steel container 120 was 100 liters. A nitrogen gas was used as the gas supplied from the gas supply pipe 105.

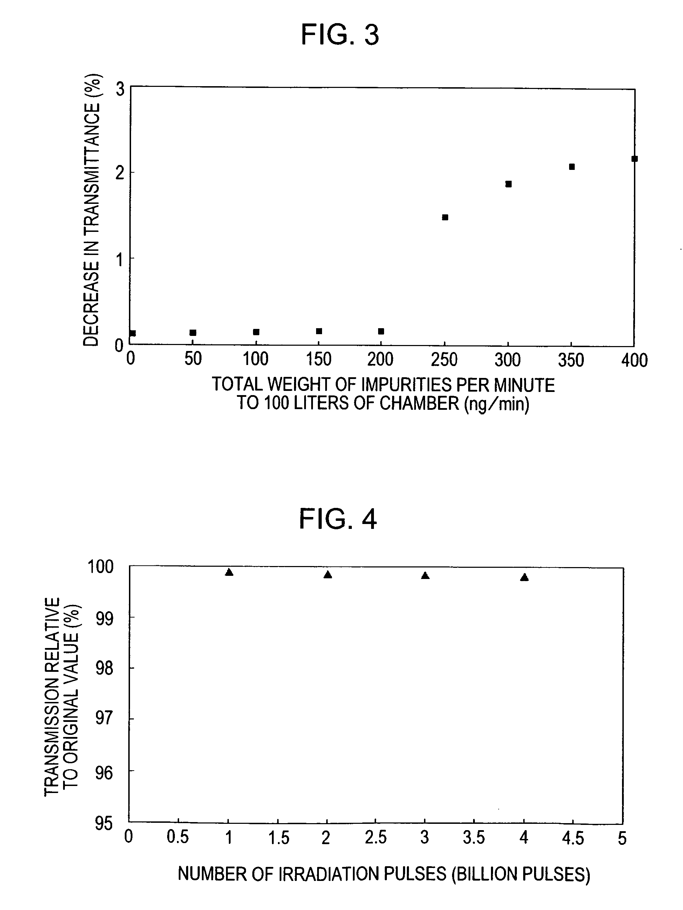

First, the total weight of impurities contained in the nitrogen gas was analyzed using a known gas chromatographic method. According to this analytical result, 1,000 ng of impurities was contained per 100 liters of the nitrogen gas. Next, the nitrogen gas was supplied to the stainless steel container 120, and the transmittance of light through the optical system 102 was measured by the detector 150 after an irradiation of 100 million pulses. When the total weight of impurities contained in the nitrogen gas supplied per one minute reached 0.1 ng, 50 ng, 100 ng, 150 ng, 200 ng,····· 400 ng (i.e. it was increased in a stepwise manner by 50 ng), the amount of light was measured at each of these measured impurity levels. This change in the total weight of impurities per minute was controlled by increasing the flow rate of the nitrogen gas supplied from the gas supply pipe 105 from 0 to 40 liters per minute in a stepwise manner by 5 liters and using the flowmeter 107 and the valves 106. The relationship between the total weight of impurities per minute per 100 liters of volume in the container 120 and the decrease in transmittance is shown in Fig. 3.

As can be seen from Fig. 3, when impurities in an amount of more than 200 ng per minute per 100 liters of volume in the container 120 are supplied to the stainless steel container 120 having an inside volume of 100 liters, the transmittance is rapidly decreased. That is, it is understood that when impurities in an amount of 2 ng or less per minute per 1 liter of the optical system container is supplied, the transmittance of the optical system can be very preferably maintained in a preferred transmittance range.

### Experimental example 2

Experimental example 2 was carried out using the experimental device shown in Fig. 2 in a manner similar to that in Experimental example 1. An ArF laser having a wavelength of 193 nm was used as the light source 101, and the highest energy density on the meniscus lens 102a was 8 mJ/cm². The inside volume of the stainless steel container 120 was 100 liters. A helium gas was used as the gas supplied from the gas supply pipe 105.

First, the total weight of impurities contained in the helium gas was analyzed using a known gas chromatographic method. According to the analytical result, 1,000 ng of impurities was contained per 100 liters of the helium gas. Next, the helium gas was supplied to the stainless steel container 120, and after irradiation was repeatedly performed a predetermined number of times, the transmittance was measured by the detector 150 as a function of the number of irradiation pulses. In this case, the flow rate of the helium gas supplied from the gas supply pipe 105 was controlled to be 10 liters/minute, so that the total weight of impurities which was supplied was 100 ng per minute. The flow rate of the helium gas was set so that 1 ng of impurities was supplied in one minute to a 1 liter volume of the 100 liter optical system container.

The transmittances are shown in Fig. 4 at 1, 2, 3, and 4 billion pulses.

As can be seen from Fig. 4, even when an irradiation of 4 billion pulses is performed, the transmittance is not substantially decreased.

### Experimental example 3

Experimental example 3 was carried out using the experimental device shown in Fig. 2 in a manner similar to that in Experimental example 1. However, the device shown in Figure 2 was modified so that the inside volume of the stainless steel container was 10 liters. A low pressure mercury lamp was used as the light source 101, and the highest energy density on the meniscus lens 102a was 0.1 mJ/cm². A nitrogen gas was used as the gas supplied from the gas supply pipe 105.

First, the total weight of impurities contained in the nitrogen gas was analyzed using a known gas chromatographic method. According to the analytical result, 1,000 ng of impurities was contained per 100 liters of the nitrogen gas. Next, after the nitrogen gas was supplied in the stainless steel container 120, irradiation was performed for a predetermined time, and the transmittance was measured by the detector 150 at different irradiation times. The flow rate of the nitrogen gas supplied from the gas supply pipe 105 was controlled to 0.5 liters/minute so that the total weight of impurities supplied to the entire 10 liter volume of the container 120 per one minute was 5 ng. That is, the nitrogen gas was supplied so that 0.5 ng of impurities was supplied in one minute to a 1 liter volume of the optical system container 120.

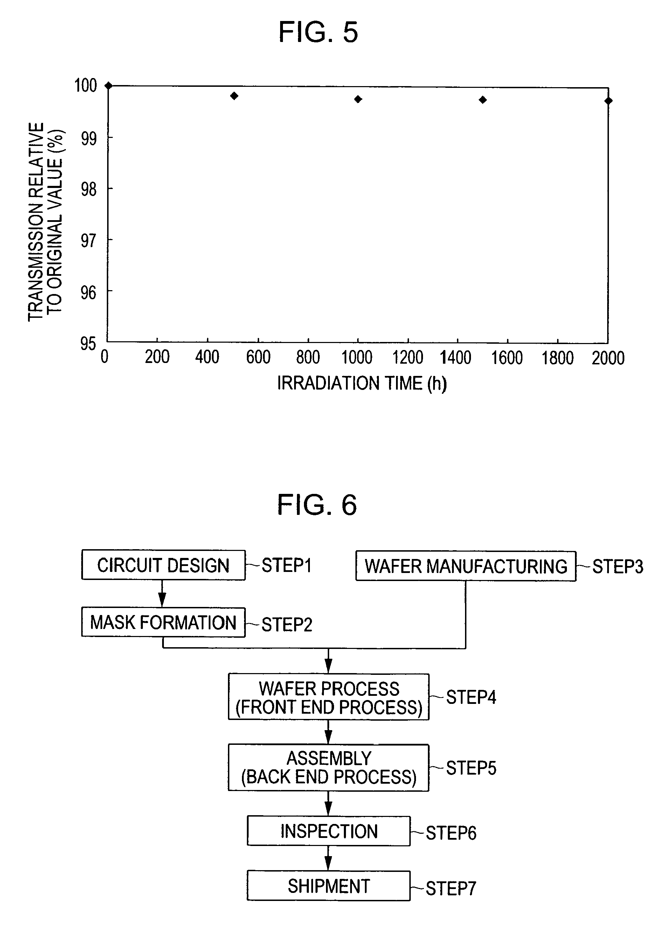

The transmittances of the optical system are shown in Fig. 5. The values for the transmittance of the optical system were obtained when irradiation was performed for 500, 1,000, 1,500, and 2,000 hours while the nitrogen gas was supplied in the stainless steel container 120. As can be seen from Fig. 5, it is understood that even when irradiation was performed for 2,000 hours, the transmittance was not substantially decreased. In this example, the highest energy density on the optical element was 0.1 mJ/cm² Thus, when the energy density is 10 mJ/cm² or less, a sufficient transmittance can be realized by the present invention. However, when the energy density is controlled to be 10 mJ/cm² or more on at least one position of the surface of the optical element as described above, the transmittance can be further improved.

### Embodiment 2

Embodiment 2 of the present invention relates to a process for manufacturing a device using the exposure apparatus according to Embodiment 1. Fig. 6 is a flowchart illustrating the whole process for manufacturing the semiconductor device. In Step 1 (circuit design), circuit design of the semiconductor device is performed. In Step 2 (mask formation), a mask is formed based on the circuit pattern thus designed.

In addition, in Step 3 (wafer manufacturing), a wafer is manufactured by a conventional process using a material such as silicon. In Step 4 (wafer process), a so-called front-end process, an actual circuit is formed on the wafer using the mask and the wafer described above by a known lithographic technique using the above exposure apparatus. In subsequent Step 5 (assembly), a so-called back-end process, semiconductor chips are formed by a conventional process using the wafer manufactured in Step 4, and in particular, in the above step, for example, assembly includes dicing and bonding and packaging includes chip encapsulation. In Step 6 (inspection), inspection, employing, for example, a conventional operation check test and a conventional durability test, of the semiconductor device manufactured in Step 5, is performed. After the steps described above, the semiconductor device is completed, and in Step 7, shipment thereof is performed.

The wafer process described in Step 4 has the following steps. That is, there are provided an oxidation step of oxidizing a surface of the wafer, a CVD (chemical vapor deposition) step of forming an insulating film on the wafer surface, an electrode forming step of forming electrodes on the wafer by vapor deposition, an ion implantation step of implanting ions into the wafer, a resist treatment step of applying a photosensitive agent on the wafer, an exposure step of transferring a circuit pattern onto the wafer processed by the resist treatment step, a development step of developing the wafer exposed in the exposure step, an etching step of etching a part other than a resist image formed by development in the development step, and a resist removing step of removing an unnecessary resist after the etching. By repeating the steps described above, multi-layered circuit patterns are formed on the wafer.

According to the embodiments, by controlling the flow rate (total weight of impurities per unit time) of the highly pure gas supplied into the optical system atmosphere, the supply of impurities, which are slightly contained in the gas, in the optical system container can be minimized. Accordingly, the decrease in transmittance with time that is caused by deposition of reaction products on the lens surfaces in the optical system can be suppressed. In addition to the transmissive optical element, the present invention may also be applied to other types of optical elements such as a reflective optical element.

The present invention is not limited to the above embodiments and various changes and modifications can be made within the spirit and scope of the present invention. For example, in addition, to argon, nitrogen, and helium, it is within the scope of the present invention to supply an inert gas comprising one of neon, xenon, and krypton into the container. To apprise the public of the scope of the present invention the following claims are provided.

## Claims

1. A method of conditioning an atmosphere inside a chamber of an exposure apparatus in which an optical element is disposed for directing light to expose a substrate, said method comprising the steps of:
supplying inert gas into the chamber; and
exhausting gas from the chamber,
wherein said supplying step adjusts the flow rate of the inert gas so that the amount of impurities supplied into the chamber is not greater than 2 nanograms per minute per 1 liter of a volume of the chamber.

2. A method according to Claim 1, wherein said supplying step supplies inert gas at a flow rate not less than 0.01 liters per minute per 100 liters of the volume of the chamber.

3. A method according to Claim 1, wherein the wavelength of the light is not greater than 250 nanometers.

4. A method according to Claim 1, wherein the energy density of the light is not less than 10 mJ/cm² in at least one region of a surface of the optical element.

5. A method according to Claim 1, wherein the inert gas includes at least one element selected from the group consisting of argon, nitrogen, helium, neon, xenon, and krypton.

6. A method according to Claim 1, further comprising the step of transmitting light through the optical system to the substrate during said supplying and exhausting steps.

7. A method according to Claim 1, further comprising the steps of measuring the total weight of the impurities contained in the inert gas per unit volume before said supplying and exhausting steps.

8. An exposure apparatus for exposing a substrate to light, said apparatus comprising:
an optical element configured to direct the light;
a chamber configured to enclose said optical element;
a supply system configured to supply an inert gas into said chamber; and
an exhaust system configured to exhaust gas from said chamber,
wherein said supply system is configured to adjust the flow rate of the inert gas so that the amount of impurities supplied into said chamber is not greater than 2 nanograms per minute per 1 liter of a volume of said chamber.

9. An apparatus according to Claim 8, wherein said supply system is configured to supply the inert gas at a flow rate not less than 0.01 liters per minute per 100 liters of the volume of said chamber.

10. An apparatus according to Claim 8, wherein said optical element is configured to direct the light whose wavelength is not greater than 250 nanometers.

11. An apparatus according to Claim 8, wherein said apparatus is configured so that the energy density of the light is not less than 10 mJ/cm² in at least one region of a surface of said optical element.

12. An apparatus according to Claim 8, wherein said supply system is configured to supply the inert gas which includes at least one element selected from the group consisting of argon, nitrogen, helium, neon, xenon, and krypton.

13. An apparatus according to Claim 8, wherein light is transmitted through said optical system during the supplying of inert gas by said supply system and during the exhausting of gas by said exhaust system.

14. An apparatus according to Claim 8, wherein said supply system comprises:
a flowmeter configured and positioned to measure the flow rate of the inert gas supplied by said supply system; and
at least one valve configured and positioned to control the flow rate of the inert gas supplied by said supply system.

15. A method of manufacturing a device, said method comprising the steps of:
supplying inert gas into a chamber of an exposure apparatus for exposing a substrate to light directed thereto by an optical element in the chamber;
exhausting gas from the chamber;
adjusting the flow rate of the inert gas so that the amount of impurities supplied into the chamber is not greater than 2 nanograms per minute per 1 liter of a volume of the chamber;
exposing the substrate to light directed thereto by the optical element using the exposure apparatus;
developing the exposed substrate; and
processing the developed substrate to manufacture the device.

16. A method according to Claim 15, wherein said supplying step supplies inert gas at a flow rate not less than 0.01 liters per minute per 100 liters of the volume of the chamber.

17. A method according to Claim 15, wherein the wavelength of the light is not greater than 250 nanometers.

18. A method according to Claim 15, wherein the energy density of the light is not less than 10 mJ/cm² in at least one region of a surface of the optical element.

19. A method according to Claim 15, wherein the inert gas includes at least one element selected from the group consisting of argon, nitrogen, helium, neon, xenon, and krypton.

20. A method according to Claim 15, further comprising the step of:
transmitting light through the optical system to the substrate during said supplying and exhausting steps.
